# EUROPEAN PATENT SPECIFICATION

(11) **EP 0 283 990 B1**
(45) Date of publication and mention of the grant of the patent: **26.01.1994**
(21) Application number: 88104462.2
(22) Date of filing: 21.03.1988
(51) Int. Cl.: G03F 7/031, G03F 7/033

(54) **A heat-resistant photosensitive resin composition**
Wärmebeständige, lichtempfindliche Harzzusammensetzung
Composition de résines photosensibles résistant à la chaleur

(30) Priority: 25.03.1987 JP 68957/87; 30.09.1987 JP 243675/87
(43) Date of publication of application: 28.09.1988
(73) Proprietor: TOKYO OHKA KOGYO CO., LTD., Kawasaki-shi Kanagawa-ken (JP)
(72) Inventor: Tazawa, Kenji, Koza-gun Kanagawa-ken (JP); Horigome, Tomoki, Fujisawa-shi Kanagawa-ken (JP); Aoyama, Toshimi 45-402, Komayose-Danchi, Fujisawa-shi Kanagawa-ken (JP); Iwata, Akira, Kawasaki-shi Kanagawa-ken (JP)
(74) Representative: Hansen, Bernd, Dr. Dipl.-Chem.

(56) References cited:
- EP-A- 0 141 921
- DE-A- 3 619 914
- CHEMICAL ABSTRACTS, vol. 104, no. 22, 2nd June 1986, page 107, abstract no. 188375u, Columbus, Ohio, US;& JP-A-60208377

## Description

The present invention relates to a photosensitive resin composition or, more particularly, to a heat-resistant photosensitive resin composition used in the manufacture of printed circuit boards as a solder resist resistant against molten solder alloy, etching resist and plating resist as characterized by the excellent heat resistance and adhesion to the substrate surface as well as high sensitivity.

It is well known in the prior art to use a photosensitive resin in the manufacture of printed circuit boards as a solder resist, etching resist or plating resist. Various kinds of photosensitive resin compositions have hitherto been proposed and are under practical use.

For example Japanese Patent Kokai 60-208377 teaches a solder resist composition comprising a phenol novolac-type and cresol novolac-type epoxy resins having a group with an ethylenically unsaturated double bond, a photopolymerization initiator and an amine-type curing agent. Japanese Patent Kokai 58-199341 teaches a heat-resistant photosensitive resin composition comprising a diallyl phthalate prepolymer, a photopolymerizable monomer and a photopolymerization initiator. Further, Japanese Patent Publication 52-43090 teaches a photopolymerizable resin composition comprising a linear polymeric compound having an N-alkoxymethyl carbamoyl group as the pendant group and a compound having at least two epoxy groups in a molecule.

While the above described photosensitive resin compositions are advantageous in respect of the excellent resistance against heat and chemicals, a serious problem therein is that the resist layer of these photosensitive resin compositions can be developed only by using a specific organic solvent such as chlorinated hydrocarbon solvents so that the use thereof is disadvantageous economically due to the expensiveness of the organic solvents used in the development treatment. In addition, it is a trend in recent years to avoid use of a chlorinated hydrocarbon solvent as far as possible in view of the problems caused by chlorinated hydrocarbon solvents in the environmental pollution and undesirable influences on the workers' health so that the number of the organic solvents usable as a developer in the development treatment of these photosensitive resin compositions is decreasing less and less.

Accordingly, efforts to solve the above mentioned problems have been directed to the development of a heat-resistant photosensitive resin composition capable of being developed with water or an aqueous alkaline solution but the photosensitive resin compositions hitherto developed are not quite satisfactory from the standpoint of practical use because of their relatively poor resistance against heat and chemicals, adhesiveness to substrate surfaces and stability in storage.

EP-A-0 141 921 discloses a photosensitive resin composition comprising a compound with at least two terminal, ethylenically unsaturated groups being capable of forming a cured polymer; a polymeric binder and a polymerization initiator being activated by radiation.

DE-A-36 19 914 reveals a heat-resistant photosensitive resin composition including a curable, linear copolymer and a monomer with ethylenically unsaturated bonds.

The present invention therefore has an object to provide a novel and improved photosensitive resin composition capable of being developed with an aqueous alkaline solution to give a resist layer having excellent resistance against heat and chemicals, adhesion to the substrate surface and electric insulation.

The heat-resistant photosensitive resin composition of the present invention obtained as a result of the investigations undertaken with the above mentioned object comprises:
(a) a copolymer obtained by the copolymerization of a monomer mixture comprising from 10 to 30% by weight of an ethylenically unsaturated amide compound represented by the general formula

   CH₂=CX-CO-NH-Y-OZ, (I)

   in which X is a hydrogen atom or methyl group, Y is an alkylene group having 1 to 4 carbon atoms and Z is an alkyl group having 1 to 4 carbon atoms or a benzyl group as a first essential monomer and from 10 to 30% by weight of an ethylenically unsaturated compound having at least one carboxyl group in a molecule as a second essential monomer;
(b) an esterified resin which is a reaction product of a novolac-type epoxy resin and an ethylenically unsaturated carboxylic acid in an amount of from 0.2 to 0.8 equivalent relative to the epoxy groups in the novolac-type epoxy resin;
(c) a photopolymerizable monomer having more than one double bond in the molecule;
(d) a photopolymerization initiator;
(e) a powdery solid material; and
(f) a curing agent for an epoxy resin.

As is described above, the inventive photosensitive resin composition contains two different resinous ingredients of which one is the copolymer as the component (a). This copolymer is a ternary copolymer obtained by the copolymerization of three different comonomers in a specified proportion. The first of the three comonomers is an ethylenically unsaturated amide compound represented by the above given general formula (I) in which the symbols X, Y and Z each have the meaning as defined above.

Exemplary of the ethylenically unsaturated amide compound suitable as the first comonomer are N-methoxymethyl acrylamide, N-methoxymethyl methacrylamide, N-ethoxymethyl acrylamide, N-ethoxymethyl methacrylamide, N-propoxymethyl acrylamide, N-propoxymethyl methacrylamide, N-n-butoxymethyl acrylamide, N-n-butoxymethyl methacrylamide, N-isobutoxymethyl acrylamide, N-isobutoxymethyl methacrylamide, N-benzyloxymethyl acrylamide, N-n-butoxyethyl acrylamide, N-n-butoxyethyl methacrylamide, N-isobutoxyethyl acrylamide, N-isobutoxyethyl methacrylamide and the like. These unsaturated amide compounds can be used either singly or as a combination of two kinds or more according to need. The amount of the unsaturated amide compound as the first comonomer in the monomeric mixture should be in the range from 10 to 30% by weight. An excessively large amount of the unsaturated amide compound in the monomeric mixture may cause a disadvantage that the developability of the photosensitive resin composition compounded with the copolymer is somewhat decreased with an aqueous alkaline developer solution. When the amount thereof is too small, on the other hand, sufficiently high heat resistance cannot be imparted to the resist layer prepared from the photosensitive resin composition.

The second comonomer in the monomeric mixture to be copolymerized into the copolymer as the component (a) is an ethylenically unsaturated compound having at least one carboxyl group in a molecule typically exemplified by acrylic acid and methacrylic acid though not limited thereto. These unsaturated carboxylic acid compounds can be used either singly or as a combination of two kinds or more according to need. The amount thereof in the monomeric mixture should be in the range from 10 to 30% by weight. When the amount is too small, the resultant photosensitive resin composition has poor developability with an aqueous alkaline solution so that no satisfactory patterning can be obtained. When the amount is too large, on the other hand, the storage stability of the photosensitive resin composition prepared from the copolymer is decreased so that the resin composition is sometimes gelled during storage in addition to the disadvantage of decrease in the electric insulation of the resist layer prepared from the photosensitive resin composition.

The third comonomer to be copolymerized with the above described first and second comonomers is an ethylenically unsaturated compound.
Exemplary of such an unsaturated compound are styrene, α-methyl styrene, methyl acrylate, methyl methacrylate, butyl acrylate, butyl methacrylate, hydroxymethyl acrylate, hydroxymethyl methacrylate, hydroxypropyl acrylate, hydroxypropyl methacrylate and the like though not limited thereto. These unsaturated compounds can be used either singly or as a combination of two kinds or more according to need. The amount of the third comonomer in the monomeric mixture should be in the range from 40 to 80% by weight. When the amount of the third comonomer is too large in the monomeric mixture, the developability of the photosensitive resin composition prepared from the copolymer is somewhat decreased with an aqueous alkaline solution as the developer solution in addition to the decrease in the heat resistance of the resist layer obtained from the resin composition. When the amount of the third comonomer is too small in the monomeric mixture, the storage stability of the resin composition may be undesirably decreased.

The copolymer as the component (a) in the inventive photosensitive resin composition serves to improve the heat resistance of the patterned resist layer formed from the resin composition. Namely, the copolymer is thermally crosslinked when the patterned resist layer after exposure to light and development treatment is subjected to a heat treatment.

The component (b) in the inventive photosensitive resin composition is an esterified resin which is a reaction product of a novolac-type epoxy resin and an ethylenically unsaturated carboxylic acid. The novolac-type epoxy resin includes phenol novolac-type epoxy resins and cresol novolac-type epoxy resins. These epoxy resins of different types can be used either singly or as combined together. These novolac-type epoxy resins can be prepared according to a known method by the reaction of epichlorohydrin or methyl epichlorohydrin with a phenol or cresol novolac resin prepared from phenol or cresol and formaldehyde.

Exemplary of the ethylenically unsaturated carboxylic acid to be reacted with the above described novolac-type epoxy resin are acrylic acid, methacrylic acid, crotonic acid, monomethyl maleate, monopropyl maleate, monobutyl maleate, sorbic acid and the like. These compounds can be used either singly or as a combination of two kinds or more according to need.

The reaction of the novolac-type epoxy resin and the above described ethylenically unsaturated carboxylic acid is performed in the presence of an esterification catalyst which may be a conventional compound used in esterification reactions including secondary and tertiary amines and salts thereof such as triethyl amine, diethyl amine hydrochloride, diethyl amine acetate and the like.

The esterified resin as the component (b) of the inventive photosensitive resin composition should be prepared by the reaction of the ethylenically unsaturated carboxylic acid in an amount in the range from 0.2 to 0.8 equivalent relative to the epoxy groups in the novolac-type epoxy resin. The esterified resin is susceptible to both of the photopolymerization by exposure to ultraviolet light and the thermal polymerization by heating since the resin has photopolymerizable ethylenically unsaturated groups and thermally polymerizable epoxy groups.

In addition to the above described copolymer as the component (a) and the esterified resin as the component (b), the inventive photosensitive resin composition should contain a photopolymerizable monomer having more than one double bond in the molecule to provide a third resinous constituent in the resist layer formed from the resin composition. Exemplary of the photopolymerizable monomer as the component (c) in the inventive resin composition are 1,6-hexane diol diacrylate, trimethylol propane triacrylate, trimethylol propane trimethacrylate, trimethylol propane diacrylate, trimethylol propane dimethacrylate, tetramethylol methane tetraacrylate, tetramethylol methane tetramethacrylate, pentaerithritol triacrylate, pentaerithritol trimethacrylate, dipentaerithritol pentaacrylate, dipentaerithritol pentamethacrylate, 1,1,1-tri(acryloxypropoxypropoxymethyl) propane of the formula C₂H₅C[CH₂O(C₃H₆O)₂COCH=CH₂]₃, melamine acrylates obtained by the reaction of 1 mole of hexamethoxy melamine with at least 1 mole of a hydroxyalkyl acrylate or hydroxyalkyl methacrylate and carboxyl-containing esterified resins obtained by the reaction of an anhydride of a dibasic carboxylic acid with hydroxy groups of the reaction product of acrylic or methacrylic acid with the epoxy groups in a phenol or cresol novolac-type epoxy resin though not limited thereto.

Among the above named photopolymerizable monomers as the component (c), the melamine acrylates have an advantage that the number of the acrylate groups can be selected from 1 to 6 according to desire by suitably adjusting the molar ratio of the hydroxyalkyl acrylate or methacrylate relative to the hexamethoxymethyl melamine. The melamine acrylate can be prepared by the reaction of hexamethoxymethyl melamine, which is obtained from melamine through hexamethylol melamine, with a hydroxyalkyl acrylate or methacrylate such as hydroxyethyl acrylate, hydroxyethyl methacrylate, hydroxypropyl acrylate, hydroxypropyl methacrylate and the like. When the melamine acrylate molecule has one or more of unreacted methoxy groups after the photopolymerization by exposure to ultraviolet light, the methoxy groups may react with the hydroxy groups in the copolymer as the component (a) and/or the esterified resin as the component (b) by heating to increase the crosslinking density so that the resultant resist layer of the resin composition may be imparted with further increased heat resistance.

The carboxyl-containing esterified resin as a type of the photopolymerizable monomer, i.e. component (c), obtained by the reaction of a dibasic carboxylic acid anhydride with the hydroxy groups formed by the reaction of acrylic or methacrylic acid and a phenol or cresol novolac-type epoxy resin, has carboxyl groups in the molecule so that the resin is highly soluble in an aqueous alkaline solution. When such an esterified resin is used as the photopolymerizable monomer, accordingly, the resin composition in the areas of the resist layer unexposed to light can readily be dissolved away with an aqueous alkaline solution as the developer in the development treatment to give an advantage of improved developability. Exemplary of the anhydride of dibasic carboxylic acid used in the preparation of the carboxyl-containing esterified resin are succinic anhydride, maleic anhydride, phthalic anhydride and the like.

The amounts of the esterified resin as the component (b) and the photopolymerizable monomer as the component (c) in the inventive photosensitive resin composition should be in the ranges of from 20 to 200 parts by weight of the component (b) and from 25 to 250 parts by weight of the component (c) per 100 parts by weight of the copolymer as the component (a).

The photopolymerization initiator as the component (d) in the inventive resin composition may be any of known ones conventionally used in photosensitive resin compositions. Exemplary of suitable photopolymerization initiators are benzophenone compounds such as benzophenone, 4,4ʹ-dimethylamino benzophenone and 4,4ʹ-diethylamino benzophenone, anthraquinone compounds such as 2-ethyl anthraquinone and tert-butyl anthraquinone, benzoin alkyl ethers such as benzoin ethyl ether and benzoin isopropyl ether, 2,2-dimethoxy-2-phenyl acetophenone, 2,2-diethoxy acetophenone, 2-chlorothioxanthone, diethyl thioxanthone, 2-hydroxy-2-methyl propiophenone, 4ʹ-isopropyl-2-hydroxy-2-methyl propiophenone and 2-methyl-1-[4-(methylthio) phenyl]-2-morpholino-1-propanone. These photopolymerization initiators can be used either singly or as a combination of two kinds or more according to need. The amount of the photopolymerization initiator in the inventive resin composition should preferably be in the range from 0.1 to 20% by weight based on the total amount of the resinous ingredients including the copolymer as the component (a), the esterified resin as the component (b) and the photopolymerizable monomer as the component (c).

The powdery solid material as the component (e) in the inventive resin composition may be inorganic or organic as exemplified by inorganic powders such as finely divided silica powder, mica flakes, talc, aluminum oxide, aluminum hydroxide, antimony oxide and the like and organic powders such as spherical benzoguanidine resins, granular polyimide resins, granular polyamide resins and the like. Although the amount of the powdery solid material as the component (e) should be adequately selected depending on the type of the powdery material and the intended application of the resin composition, it should be in the range from about 1 to about 70% by weight based on the total amount of the resinous ingredients in the resin composition, i.e. components (a), (b) and (c), as a rough measure.

The component (f) in the inventive photosensitive resin composition is a curing agent of epoxy resins which may be any of conventional amine-based curing agents, acid anhydride-based curing agents, phenolic resins, melamine resins, cationic epoxy curing agents and the like. Preferably, however, the component (f) should be an amine-based curing agent or cationic epoxy curing agent because the sensitivity of the photosensitive resin composition is little influenced by the addition of these curing agents. Exemplary of the curing agents belonging to these classes are imidazole compounds such as 2-ethyl-4-methyl imidazole, 1-cyanoethyl-2-phenyl imidazole, 2-phenyl-4,5-dihydroxymethyl imidazole, isocyanuric acid adduct of 2-methyl imidazole (available as 2MZ-OK from Shikoku Kasei Kogyo Co.) and 1-(4,5-diamino-2-triazinyl)-2-(2-methyl-1-imidazolyl ethane (available as 2MZ-AZINE from Shikoku Kasei Kogyo Co.), tertiary amine compounds such as benzyl methyl amine and dimethylamino methyl phenol, complex compounds of amines such as boron trifluoride-monoethyl amine and boron trifluoride-triethanol amine, a cationic epoxy curing agent capable of forming a Lewis acid by exposure to ultraviolet light (available as CG-24-61 from Ciba Geigy Co.) and the like.

The amount of these epoxy curing agents in the inventive resin composition should be in the range from 1 to 20% by weight or, preferably, from 2 to 10% by weight based on the amount of the esterified resin as the component (b). When the amount of the epoxy curing agent is too small, thermal curing of the resin composition takes a long time due to the deficiency in the curing effect. When the amount thereof is too large, on the other hand, the storage stability of the resin composition may be somewhat decreased.

In addition to the above described essential ingredients of the components (a) to (f), the inventive photosensitive resin composition may optionally be admixed with various kinds of known additives such as a silicone-based or fluorine-containing antifoam agent, polymerization inhibitor, e.g., hydroquinone, methyl hydroquinone and hydroquinone monomethyl ether, coloring agent, e.g., dyes and pigments, and so on.

It is usual that the inventive photosensitive resin composition is used as diluted with an organic solvent. Suitable organic solvents include ether-type solvents such as ethylene glycol monomethyl ether, ethylene glycol monoethyl ether, ethylene glycol monobutyl ether, propylene glycol monomethyl ether, diethylene glycol monoethyl ether, dipropylene glycol monomethyl ether and the like and ketone solvents such as methyl ethyl ketone, methyl isobutyl ketone, cyclohexanone and the like. It is further optional to use a petroleum-based solvent as a diluent to adjust the viscosity or consistency of the inventive photosensitive resin composition. Suitable petroleum-based solvents include various commerical products, for example, sold under the tradenames of Swazol by Maruzen Petroleum Co. and Solvesso by Tonen Petrochemical Co.

Following is a description of a typical application of the inventive photosensitive resin composition as a material of resist on a substrate surface.

When the inventive heat-resistant photosensitive resin composition is used for a solder resist, a printed circuit board bearing a circuit pattern thereon and provided with a through-hole is coated on both sides with the composition by using a coating apparatus such as a roller coater, curtain flow coater and the like followed by drying and then the coating layer is exposed patternwise to ultraviolet light through a negative photomask and then developed by selectively dissolving away the resin composition on the unexposed areas with a weakly alkaline aqueous solution of, for example, sodium carbonate as a developer solution. The development treatment should be followed by a heat treatment at a temperature of 100 to 200 °C so that thermal curing proceeds in the resist layer and the resist layer is imparted with further increased heat resistance to meet the requirement for a solder resist.

When the inventive resin composition is used as a plating resist, for example, a copper-foiled laminated plate is coated on both sides with the resin composition by using a roller coater and the like followed by drying and then the coating layer is exposed pattern-wise to ultraviolet light through a negative photomask and developed in the same manner as above to form a patterned layer which serves as a plating resist. The plating treatment should be performed preferably in a neutral or acidic plating bath.

When the inventive resin composition is used as an etching resist, a patterned layer of the resin composition is formed on a copper-foiled laminated plate in the same manner as above and the copper foil exposed bare is removed by etching using an etching solution such as an aqueous solution of iron (III) chloride and the like. The patterned resist layer after the etching treatment can easily be removed by dissolving away with a strongly alkaline aqueous solution of, for example, sodium hydroxide and the like.

In the following, the present invention is described in more detail by way of examples, in which the terms of "parts" and "%" all refer to "parts by weight" and "% by weight", respectively.

### Example 1.

Into a flask having a separable cover and equipped with a thermometer, stirrer and reflux condenser were introduced 40 parts of methyl methacrylate, 20 parts of styrene, 20 parts of methacrylic acid, 20 parts of N-isobutoxymethyl acrylamide (IBMA, a product by Nitto Riken Kogyo Co.), 60 parts of ethylene glycol monobutyl ether, 40 parts of diethylene glycol monoethyl ether and 2 parts of 2,2ʹ-azobis(2,4-dimethyl valeronitrile (V-65, a product by Wako Junyaku Co.) as a radical polymerization initiator to form a polymerization mixture which was heated at 70 °C to effect the polymerization reaction. The thus obtained product, which is referred to as the copolymer A hereinbelow, had an acid value of 130 and an average molecular weight of about 48,000.

Separately, an esterified resin having an acid value of 2 or smaller, which is referred to as the esterified resin A hereinbelow, was prepared by heating a reaction mixture composed of 2000 parts of a cresol novolac-type epoxy resin having a softening point of 60 to 70 °C and an epoxy equivalent of 200 to 230 (YDCN 701, a product by Toto Kasei Kogyo Co.), 268 parts of acrylic acid, 0.6 part of methyl hydroquinone and 2.9 parts of triethyl amine at 100 °C for 15 hours.

A uniform photosensitive resin composition was prepared by thoroughly kneading, on a three-roller mill, a blend composed of 100 parts of the copolymer A, 40 parts of the esterified resin A, 30 parts of trimethylol propane triacrylate (A-TMPT, a product by Shin-Nakamura Kagaku Co.), 3 parts of diethyl thioxanthone (DETX, a product by Nippon Kayaku Co.), 4 parts of 2,2-dimethoxy-2-phenyl acetophenone (Irgacure 651, a product by Ciba Geigy Co.), 6 parts of a finely divided fumed silica filler (Aerosil #200, a product by Nippon Aerosil Co.), 3 parts of 2-phenyl-4,5-dihydroxy methyl imidazole (2PHZ, a product by Shikoku Kasei Kogyo Co.) and 2 parts of a silicone-based antifoam agent (KS-603, a product by Shin-Etsu Chemical Co.).

The thus prepared resin composition was applied to a side of a printed circuit board having a through-hole by using a roller coater and dried by heating at 80 °C for 15 minutes. Similarly, the other side of the printed circuit board was coated with the resin composition and dried by heating at 80 °C for 30 minutes. After cooling to room temperature, the coating layers of the resin composition were simultaneously exposed pattern-wise to ultraviolet light each in a dose of 400 mJ/cm² through a negative photomask and then developed by dissolving away the resin composition on the unexposed areas taking 100 seconds with a 1.5% aqueous solution of sodium carbonate at 30 °C. Thereafter, the printed circuit board was heated at 140 °C for 60 minutes to effect thermal curing of the resin composition to give a printed circuit board provided with a patterned solder resist layer formed thereon.

The printed circuit board was coated with a rosin-based flux having a pH of 2 to activate the metal-made terminals around the through-hole and then immersed for 1 minute in a bath of a molten solder alloy at 260 °C to find no discoloration or blistering of the resist layer on the circuit pattern. Further, the printed circuit board was immersed for 10 minutes in boiling methylene chloride with an object to remove the rosin-based flux but no changes were noted at all in the appearance.

### Example 2.

Into a flask having a separable cover and equipped with a thermometer, stirrer and reflux condenser were introduced 40 parts of methyl methacrylate, 20 parts of styrene, 20 parts of methacrylic acid, 20 parts of N-n-butoxyethyl acrylamide, 60 parts of ethylene glycol monobutyl ether, 40 parts of diethylene glycol monoethyl ether and 3 parts of 2,2ʹ-azobis(2,4-dimethyl valeronitrile) (V-65, supra) as a radical polymerization initiator to form a polymerization mixture which was heated at 70 °C to effect the polymerization reaction. The thus obtained product, which is referred to as the copolymer B hereinbelow, had an acid value of 130 and an average molecular weight of 38,000.

Separately, an esterified resin, which is referred to as the esterified resin B hereinbelow, was prepared in the same manner as in the preparation of the esterified resin A excepting the use of 1800 parts of a phenol novolac-type epoxy resin having a softening point of 60 to 70 °C and an epoxy equivalent of 170 to 190 (YDPM 638, a product by Toto Kasei Kogyo Co.) and 365 parts of acrylic acid.

A uniform photosensitive resin composition was prepared by thoroughly kneading, on a three-roller mill, a blend composed of 100 parts of the copolymer B, 40 parts of the esterified resin B, 30 parts of trimethylol propane triacrylate, 4 parts of benzophenone, 1 part of 4,4ʹ-diethylamino benzophenone, 6 parts of a finely divided fumed silica filler (Aerosil #300, a product by Nippon Aerosil Co.) and 1.5 parts of 2-phenyl-4,5-dihydroxy methyl imidazole (2PHZ, supra).

The thus prepared resin composition was applied to a side of a printed circuit board having a through-hole through a polyester filament-made screen of 150 mesh fineness and dried by heating at 80 °C for 15 minutes. Similarly, the other side of the printed circuit board was coated with the resin composition and dried by heating at 80 °C for 30 minutes. After cooling to room temperature, the coating layers of the resin composition were simultaneously exposed pattern-wise to ultraviolet light each in a dose of 500 mJ/cm² through a negative photomask and then developed by dissolving away the resin composition on the unexposed areas taking 100 seconds with a 1.5% aqueous solution of sodium carbonate at 30 °C. Thereafter, the printed circuit board was heated at 140 °C for 60 minutes to effect thermal curing of the resin composition to give a printed circuit board having a patterned layer of solder resist formed thereon.

The printed circuit board was coated with a rosin-based flux having a pH of 2 to activate the metal-made terminals around the through-hole and then immersed for 1 minute in a bath of a molten solder alloy at 260 °C to find no discoloration or blistering of the resist layer on the circuit pattern. Further, the printed circuit board was immersed for 10 minutes in boiling methylene chloride with an object to remove the rosin-based flux but no changes were noted at all in the appearance.

### Example 3.

Into a flask having a separable cover and equipped with a thermometer, stirrer and reflux condenser were introduced 45 parts of methyl methacrylate, 15 parts of styrene, 15 parts of methacrylic acid, 15 parts of N-n-butoxymethyl acrylamide, 60 parts of ethylene glycol monobutyl ether, 60 parts of diethylene glycol monoethyl ether and 3 parts of 2,2ʹ-azobis(2,4-dimethyl valeronitrile (V-65, supra) as a radical polymerization initiator to form a polymerization mixture which was heated at 70 °C to effect the polymerization reaction. The thus obtained product, which is referred to as the copolymer C hereinbelow, had an acid value of 150 and an average molecular weight of 46,000.

A uniform photosensitive resin composition was prepared by thoroughly kneading, on a three-roller mill, 100 parts of the above obtained copolymer C, 20 parts of the esterified resin A prepared in Example 1, 20 parts of the esterified resin B prepared in Example 2, 40 parts of trimethylol propane triacrylate, 5 parts of diethyl thioxanthone (DETX, supra), 3 parts of 2,2-dimethoxy-2-phenyl acetophenone, 6 parts of a finely divided fumed silica filler (Aerosil #300, supra), 4 parts of 2-phenyl-4,5-dihydroxy methyl imidazole (2PHZ, supra) and 2 parts of a silicone-based antifoam agent (KS-603, supra).

The thus prepared photosensitive resin composition was applied to a side of a printed circuit board having a through-hole through a polyester filament-made screen of 150 mesh fineness and dried by heating at 80 °C for 15 minutes. Similarly, the other side of the printed circuit board was coated with the resin composition and dried by heating at 80 °C for 30 minutes. After cooling to room temperature, the coating layers of the resin composition were simultaneously exposed pattern-wise to ultraviolet light each in a dose of 400 mJ/cm² through a negative photomask and then developed by dissolving away the resin composition on the unexposed areas taking 120 seconds at 35 °C with a 1.0% aqueous solution of sodium carbonate. Thereafter, thermal curing of the resin composition was performed by heating at 140 °C for 60 minutes to give a printed circuit board having a patterned layer of solder resist formed on both surfaces.

The printed circuit board was coated with a rosin-based flux having a pH of 2 to activate the metal-made terminals around the through-hole followed by immersion thereof in a bath of a molten solder alloy at 260 °C for 30 seconds and then in methylene chloride for 60 minutes to find absolutely no changes. A peeling test was undertaken using a cellophane-based pressure-sensitive adhesive tape to find that the adhesion of the resist layer was excellent.

### Example 4.

A uniform photosensitive resin composition was prepared by thoroughly kneading, on a three-roller mill, 100 parts of the copolymer A prepared in Example 1, 40 parts of the esterified resin A prepared in Example 1, 60 parts of a phenol movolac-type epoxy acrylate resin having carboxyl groups (SP-4300-1X, a product by Showa Kobunshi Co.), 30 parts of trimethoxy methyl melamine trimethoxyethyl acrylate (Nicalac MX-302, a product by Sanwa Chemical Co.), 20 parts of trimethylol propane triacrylate, 20 parts of pentaerithritol tetraacrylate, 5 parts of diethyl thioxanthone (DETX, supra), 4 parts of 2,2-dimethoxy-2-phenyl acetophenone (Irgacure 651, supra), 10 parts of a finely divided fumed silica filler (Aerosil #300, supra), 60 parts of talc (Talc P-4, a product by Nippon Talc Co.), 3 parts of 1-(4,5-diamino-2-triazinyl)-2-(2-methyl-1-imidazolyl) ethane (2MZ-AZINE, a product by Shikoku Kasei Kogyo Co.), 1 part of cyanine green and 2 parts of a silicone-based antifoam agent (KS-603, supra).

The thus prepared photosensitive resin composition was applied to a side of a printed circuit board having a through-hole through a polyester filament-made screen of 150 mesh fineness and dried by heating at 80 °C for 15 minutes. Similarly, the other side of the printed circuit board was coated with the resin composition and dried by heating at 80 °C for 30 minutes. After cooling to room temperature, the coating layers of the resin composition were simultaneously exposed pattern-wise to ultraviolet light each in a dose of 600 mJ/cm² through a negative photomask and then developed at 30 °C taking 80 seconds by dissolving away the resin composition on the unexposed areas with a 1.0% aqueous solution of sodium carbonate. Thereafter, thermal curing of the resin composition was performed by heating at 140 °C for 60 minutes to give a printed circuit board having a patterned layer of solder resist formed thereon.

The printed circuit board was coated with a rosin-based flux having a pH of 2 to activate the metal-made terminals around the through-hole and then immersed for 1 minute in a bath of a molten solder alloy at 260 °C to find no discoloration or blistering in the resist layer on the circuit pattern. Further, the printed circuit board was immersed for 10 minutes in boiling methylene chloride with an object to remove the rosin-based flux to find absolutely no changes in the appearance. In addition, it was immersed for 10 minutes in ethylene glycol monoethyl ether under boiling also to find absolutely no changes in the appearance.

### Example 5.

A uniform photosensitive resin composition was prepared by thoroughly kneading, on a three-roller mill, 100 parts of the copolymer C prepared in Example 3, 50 parts of the esterified resin B prepared in Example 2, 60 parts of a phenol novolac-type epoxy acrylate resin having carboxyl groups (SP-4300-1X, supra), 40 parts of trimethoxy methyl melamine trimethoxy ethyl acrylate (Nicalac MX-302, supra), 30 parts of trimethylol propane triacrylate, 20 parts of dipentaerithritol pentaacrylate, 3 parts of diethyl thioxanthone (DETX, supra), 4 parts of 2,2-dimethoxy-2-phenyl acetophenone (Irgacure 651, supra), 10 parts of a finely divided fumed silica filler (Aerosil #380, a product by Nippon Aerosil Co.), 50 parts of barium sulfate, 4 parts of 2-phenyl-4,5-dihydroxy methyl imidazole (2PHZ, supra), 1 part of cyanine green and 2 parts of a silicone-based antifoam agent (KS-603, supra).

The thus prepared photosensitive resin composition was applied to a side of a printed circuit board having a through-hole and a circuit pattern formed thereon through a polyester filament-made screen of 150 mesh fineness and dried by heating at 80 °C for 15 minutes. Similarly, the other side of the printed circuit board was coated with the resin composition and dried by heating at 80 °C for 30 minutes. After cooling to room temperature, the coating layers of the resin composition were simultaneously exposed pattern-wise to ultraviolet light each in a dose of 600 mJ/cm² through a negative photomask and then developed at 30 °C taking 80 seconds by dissolving away the resin composition on the unexposed areas with a 1.0% aqueous solution of sodium carbonate. Thereafter, thermal curing of the resin composition was performed by heating at 140 °C for 60 minutes to give a printed circuit board having patterned layer of solder resist formed on both surfaces.

The printed circuit board was coated with a rosin-based flux having a pH of 2 to activate the metal-made terminals around the through-hole and then immersed for 1 minute in a bath of a molten solder alloy at 260 °C to find no discoloration or blistering in the resist layer on the circuit pattern. Further, the printed circuit board was immersed for 10 minutes in boiling methylene chloride with an object to remove the rosin-based flux to find absolutely no changes in the appearance.

### Example 6.

The photosensitive resin composition prepared in Example 2 was applied to all over the surface of a copper-foiled laminated plate by using a roller coater and dried by heating at 80 °C for 30 minutes. After cooling to room temperature, the coating layer of the resin composition was exposed pattern-wise to ultraviolet light in a dose of 400 mJ/cm² through a negatively patterned photomask and then developed by dissolving away the resin composition on the unexposed areas at 30 °C taking 60 seconds with a 1.0% aqueous solution of sodium carbonate to form a patterned resist layer on the laminated plate. This circuit board was subjected to electrolytic plating of copper in a plating bath containing copper sulfate to form a plating layer of copper having a thickness of 20 µm. The patterned layer formed by this plating treatment was very sharp and well demarcated without the plating layer of copper going behind the resist layer.

### Example 7.

The photosensitive resin composition prepared in Example 1 was applied to the surface of a copper-foiled laminated plate through a polyester filament-made screen of 150 mesh fineness and dried by heating at 80 °C for 30 minutes. After cooling to room temperature, the coating layer of the photosensitive resin composition was exposed pattern-wise to ultraviolet light in a dose of 500 mJ/cm² through a negatively patterned photomask and then developed at 30 °C taking 60 seconds by dissolving away the resin composition on the unexposed areas with a 1.0% aqueous solution of sodium carbonate to form a patterned resist layer.

The copper-foiled laminated plate having the thus patterned resist layer was subjected to an etching treatment with an aqueous solution of iron (III) chloride by dissolving away the copper foil in the areas unprotected by the resist layer. After the etching treatment, the patterned resist layer was removed by dissolving away with a 1.0% aqueous solution of sodium hydroxide at 40 °C. The thus obtained circuit pattern of copper foil on the laminated plate was a reproduction of the pattern on the negative photomask with high fidelity.

### Comparative Example 1.

Into a flask having a separable cover and equipped with a thermometer, stirrer and reflux condenser were introduced 60 parts of methyl methacrylate, 20 parts of isobutyl methacrylate, 20 parts of methacrylic acid, 60 parts of ethylene glycol monobutyl ether, 40 parts of diethylene glycol monoethyl ether and 2 parts of 2,2ʹ-azobis(2,4-dimethyl valeronitrile) (V-65, supra) as a polymerization initiator and the mixture was heated at 70 °C to perform the polymerization reaction. The thus prepared copolymer, which is referred to as the copolymer D hereinbelow, had an acid value of 130 and an average molecular weight of 45,000.

A uniform photosensitive resin composition was prepared by thoroughly kneading, on a three-roller mill, 100 parts of the above obtained copolymer D, 30 parts of trimethylol propane triacrylate, 3 parts of diethyl thioxanthone (DETX, supra), 4 parts of 2,2-dimethoxy-2-phenyl acetophenone (Irgacure 651, supra), 6 parts of a finely divided fumed silica filler (Aerosil #300, supra), 3 parts of 2-phenyl-4,5-dihydroxy methyl imidazole (2PHZ, supra) and 2 parts of a silicone-based antifoam agent (KS-603, supra).

The thus obtained photosensitive resin composition was applied to a side of a printed circuit board having a circuit pattern formed in advance through a polyester filament-made screen of 150 mesh fineness and dried by heating at 80 °C for 10 minutes. Similarly, the resin composition was applied to the other side of the circuit board and dried by heating at 80 °C for 20 minutes. After cooling to room temperature, the layers of the photosensitive resin composition were simultaneously exposed pattern-wise to ultraviolet light each in a dose of 400 mJ/cm² through a negatively patterned photomask and then developed at 30 °C taking 100 seconds by dissolving away the resin composition on the unexposed areas with a 1.5% aqueous solution of sodium carbonate followed by thermal curing of the resin composition at 140 °C for 60 minutes to give a printed circuit board on which patterned layers of solder resist were formed on both surfaces.

The solvent resistance of the resist layer was examined by immersing the circuit board in methylene chloride and methyl ethyl ketone to find that the resinous resist layer became swollen with the solvent and fell off the circuit pattern indicating poor solvent resistance of the resist layer.

### Comparative Example 2.

A uniform photosensitive resin composition was prepared by thoroughly kneading, on a three-roller mill, 100 parts of the copolymer A prepared in Example 1, 40 parts of trimethylol propane triacrylate, 30 parts of a cresol novolac-type epoxy resin (YDCN-701, a product by Toto Kasei Kogyo Co.), 3 parts of diethyl thioxanthone (DETX, supra), 4 parts of 2,2-dimethoxy-2-phenyl acetophenone (Irgacure 651, supra), 6 parts of a finely divided fumed silica filler (Aerosil #300, supra), 3 parts of 2-phenyl-4,5-dihydroxy methyl imidazole (2PHZ, supra) and 2 parts of a silicone-based antifoam agent (KS-603, supra).

The thus prepared photosensitive resin composition was applied to a side of a printed circuit board having a circuit pattern formed in advance through a polyester filament-made screen of 150 mesh fineness and dried by heating at 80 °C for 20 minutes. After cooling to room temperature, the layer of the photosensitive resin composition was exposed pattern-wise to ultraviolet light in a dose of 500 mJ/cm² through a negatively patterned photomask and then a development treatment was undertaken at 30 °C with a 1.5% aqueous solution of sodium carbonate to remove the resin composition by dissolving but the attempt of the development treatment was unsuccessful not to give a printed circuit board having a patterned resist layer as desired due to whitening and swelling of the layer of the resin composition on the areas exposed to ultraviolet light.

## Claims

1. A heat-resistant photosensitive resin composition which comprises:
(a) a copolymer obtained by the copolymerization of a monomer mixture comprising from 10 to 30% by weight of an ethylenically unsaturated amide compound represented by the general formula
CH₂=CX-CO-NH-Y-OZ,
in which X is a hydrogen atom or methyl group, Y is an alkylene group having 1 to 4 carbon atoms and Z is an alkyl group having 1 to 4 carbon atoms or a benzyl group as a first essential monomer and from 10 to 30% by weight of an ethylenically unsaturated compound having at least one carboxyl group in a molecule as a second essential monomer;
(b) an esterified resin which is a reaction product of a novolac-type epoxy resin and an ethylenically unsaturated carboxylic acid in an amount of from 0.2 to 0.8 equivalent relative to the epoxy groups in the novolac-type epoxy resin;
(c) a photopolymerizable monomer having more than one double bond in the molecule;
(d) a photopolymerization initiator;
(e) a powdery solid material; and
(f) a curing agent for an epoxy resin.

2. The heat-resistant photosensitive resin composition as claimed in claim 1 wherein the first monomer of the component (a) is selected from the group consisting of N-methoxymethyl acrylamide, N-methoxymethyl methacrylamide, N-ethoxymethyl acrylamide, N-ethoxymethyl acrylamide, N-ethoxymethyl methacrylamide, N-propoxymethyl acrylamide, N-propoxymethyl methacrylamide, N-n-butoxymethyl acrylamide, N-n-butoxymethyl methacrylamide, N-isobutoxymethyl acrylamide, N-isobutoxymethyl methacrylamide, N-benzyloxymethyl acrylamide, N-n-butoxyethyl acrylamide, N-n-butoxyethyl methacrylamide, N-isobutoxyethyl acrylamide and N-isobutoxyethyl methacrylamide.

3. The heat-resistant photosensitive resin composition as claimed in claim 1 wherein the second monomer of the component (a) is acrylic acid or methacrylic acid.

4. The heat-resistant photosensitive resin composition as claimed in claim 1 wherein the ethylenically unsaturated carboxylic acid reacted with a novolac-type epoxy resin to form the component (b) is selected from the group consisting of acrylic acid, methacrylic acid, crotonic acid, monomethyl maleate, monopropyl maleate, monobutyl maleate and sorbic acid.

5. The heat-resistant photosensitive resin composition as claimed in claim 1 wherein the photopolymerizable monomer as the component (c) is selected from the group consisting of 1,6-hexane diol diacrylate, trimethylol propane triacrylate, trimethylol propane trimethacrylate, trimethylol propane diacrylate, trimethylol propane dimethacrylate, tetramethylol methane triacrylate, tetramethylol methane trimethacrylate, tetramethylol propane tetraacrylate, tetramethylol propane tetramethacrylate, dipentaerithritol pentaacrylate, dipentaerithritol pentamethacrylate, 1,1,1-tri(acryloxypropoxy propoxymethyl) propane, melamine acrylates and carboxyl group-containing esterified resins.

6. The heat-resistant photosensitive resin composition as claimed in claim 1 wherein the amount of the esterified resin as the component (b) is in the range from 20 to 200 parts by weight per 100 parts by weight of the copolymer as the component (a).

7. The heat-resistant photosensitive resin composition as claimed in claim 1 wherein the amount of the photopolymerizable monomer as the component (c) is in the range from 25 to 250 parts by weight per 100 parts by weight of the copolymer as the component (a).

8. The heat-resistant photosensitive resin composition as claimed in claim 1 wherein the photopolymerization initiator as the component (d) is selected from the group consisting of benzophenone compounds, anthraquinone compounds, benzoin alkyl ether compounds, 2,2-dimethoxy-2-phenyl acetophenone, 2,2-diethoxy acetophenone, 2-chloro thioxanthone, diethyl thioxanthone, 2-hydroxy-2-methyl propiophenone, 4ʹ-isopropyl-2-hydroxy-2-methyl propiophenone and 2-methyl-1-[4-(methylthio)phenyl]-2-morpholino-1-propanone.

9. The heat-resistant photosensitive resin composition as claimed in claim 1 wherein the amount of the photopolymerization initiator as the component (d) is in the range from 0.1 to 20% by weight based on the total amount of the copolymer as the component (a), the esterified resin as the component (b) and the photopolymerizable monomer as the component (c).

10. The heat-resistant photosensitive resin composition as claimed in claim 1 wherein the powdery solid material as the component (e) is selected from the group consisting of finely divided silica powder, mica flakes, talc, aluminum oxide, aluminum hydroxide, antimony oxide, spherical benzoguanidine resin, granular polyimide resin and granular polyamide resin.

11. The heat-resistant photosensitive resin composition as claimed in claim 1 wherein the amount of the powdery solid material is in the range from 1 to 70% by weight based on the resinous ingredients in the composition.

12. The heat-resistant photosensitive resin composition as claimed in claim 1 wherein the curing agent for an epoxy resin as the component (f) is selected from the group consisting of amine-based curing agents and cationic epoxy curing agents.

13. The heat-resistant photosensitive resin composition as claimed in claim 1 wherein the amount of the curing agent as the component (f) is in the range from 1 to 20% by weight based on the amount of the esterified resin as the component (b).

14. The heat-resistant photosensitive resin composition as claimed in claim 1 which further comprises an organic solvent.

15. The heat-resistant photosensitive resin composition as claimed in claim 15 wherein the organic solvent is selected from the group consisting of ethylene glycol monomethyl ether, ethylene glycol monoethyl ether, ethylene glycol monobutyl ether, propylene glycol monomethyl ether, diethylene glycol monoethyl ether, dipropylene glycol monomethyl ether, methyl ethyl ketone, methyl isobutyl ketone and cyclohexanone.

## Patentansprüche

1. Wärmebeständige, lichtempfindliche Harzzusammensetzung, welche
(a) ein Copolymer, das durch Copolymerisation einer Monomer-Mischung erhalten wird, wobei die Monomermischung 10 bis 30 Gew.-% einer ethylenartig ungesättigten Amidverbindung, die durch die allgemeine Formel
CH₂=CX-CO-NH-Y-OZ
dargestellt wird, in der Y eine Alkylengruppe mit 1 bis 4 Kohlenstoffatomen und Z eine Alkylgruppe mit 1 bis 4 Kohlenstoffatomen oder eine Benzylgruppe ist, als ein erstes wesentliches Monomer und 10 bis 30 Gew.-% einer ethylenartig ungesättigten Verbindung, die mindestens eine Carboxylgruppe in einem Molekül enthält, als ein zweites wesentliches Monomer enthält;
(b) ein verestertes Harz, das ein Reaktionsprodukt eines Epoxyharzes des Novolak-Typs und einer ethylenartig ungesättigten Carbonsäure in einer Menge von 0,2 bis 0,8 Äquivalenten, bezogen auf die Epoxygruppen im Epoxyharz des Novolak-Typs, ist;
(c) ein photopolymerisierbares Monomer, das mehr als eine Doppelbindung im Molekül hat;
(d) einen Photopolymerisations-Initiator;
(e) ein pulveriges Festmaterial; und
(f) ein Härtungsmittel für ein Epoxyharz umfaßt.

2. Wärmebeständige lichtempfindliche Harzzusammensetzung nach Anspruch 1, bei der das erste Monomer der Komponente (a) aus der aus N-Methoxymethylacrylamid, N-Methoxymethylmethacrylamid, N-Ethoxymethylacrylamid, N-Ethoxymethylmethacrylamid, N-Propoxymethylacrylamid, N-Propoxymethylmethacrylamid, N-n-Butoxymethylacrylamid, N-n-Butoxymethylmethacrylamid, N-Isobutoxymethylacrylamid, N-Isobutoxymethylmethacrylamid, N-Benzyloxymethylacrylamid, N-n-Butoxyethylacrylamid, N-n-Butoxyethylmethacrylamid, N-Isobutoxyethylacrylamid und N-Isobutoxyethylmethacrylamid bestehenden Gruppe ausgewählt ist.

3. Wärmebeständige lichtempfindliche Harzzusammensetzung nach Anspruch 1, bei der das zweite Monomer der Komponente (a) Acrylsäure oder Methacrylsäure ist.

4. Wärmebeständige lichtempfindliche Harzzusammensetzung nach Anspruch 1, bei der die ethylenartig ungesättigte Carbonsäure, die mit einem Epoxyharz des Novolak-Typs unter Bildung der Komponente (b) umgesetzt wurde, aus der aus Acrylsäure, Methacrylsäure, Crotonsäure, Monomethylmaleat, Monopropylmaleat, Monobutylmaleat und Sorbinsäure bestehenden Gruppe ausgewählt ist.

5. Wärmebeständige lichtempfindliche Harzzusammensetzung nach Anspruch 1, bei der das photopolymerisierbare Monomer als die Komponente (c) aus der aus 1,6-Hexandioldiacrylat, Trimethylolpropan-Triacrylat, Trimethylolpropantrimethacrylat, Trimethylolpropan-Diacrylat, Trimethylolpropandimethacrylat, Tetramethylolmethan-Triacrylat, Tetramethylolpropan-Tetraacrylat, Tetramethylolpropan-Tetramethacrylat, Dipentaerithritol-Pentaacrylat, Dipentaerithritol-Pentamethacrylat, 1,1,1-Tri(acryloxypropoxypropoxymethyl)propan, Melaminacrylaten und veresterten Harzen, die Carboxylgruppen enthalten, bestehenden Gruppe ausgewählt ist.

6. Wärmebeständige lichtempfindliche Harzzusammensetzung nach Anspruch 1, bei der die Menge des veresterten Harzes als Komponente (b) im Bereich von 20 bis 200 Gewichtsteile pro 100 Gewichtsteile Copolymer als Komponente (a) liegt.

7. Wärmebeständige lichtempfindliche Harzzusammensetzung nach Anspruch 1, bei der die Menge des photopolymerisierbaren Monomer als Komponente (c) im Bereich von 25 bis 250 Gewichtsteile pro 100 Gewichtsteile Copolymer als Komponente (a) liegt.

8. Wärmebeständige lichtempfindliche Harzzusammensetzung nach Anspruch 1, bei der der Photopolymerisations-Initiator als Komponente (d) aus der aus Benzophenon-Verbindungen, Anthrachinon-Verbindungen, Benzoinalkylether-Verbindungen, 2,2-Dimethoxy-2-phenylacetophenon, 2,2-Diethoxyacetophenon, 2-Chlorthioxanthon, Diethylthioxanthon, 2-Hydroxy-2-methylpropiophenon, 4'-Isopropyl-2-hydroxy-2-methylpropiophenon und 2-Methyl-1-[4-(methylthio)phenyl]-2-morpholino-1-propanon bestehenden Gruppe ausgewählt ist.

9. Wärmebeständige lichtempfindliche Harzzusammensetzung nach Anspruch 1, bei der die Menge des Photopolymerisations-Initiators als Komponente (d) im Bereich von 0,1 bis 20 Gew.-%, bezogen auf die Gesamtmenge aus Copolymer als Komponente (a), verestertes Harz als Komponente (b) und photopolymerisierbares Monomer als Komponente (c), liegt.

10. Wärmebeständige lichtempfindliche Harzzusammensetzung nach Anspruch 1, bei der das pulverige Festmaterial als Komponente (e) aus der aus fein verteiltem Siliciumdioxidpulver, Glimmerflocken, Talk, Aluminiumoxid, Aluminiumhydroxid, Antimonoxid, kugelförmigem Benzoguanidin-Harz, granuliertem Polyimidharz und körnigem Polyamidharz bestehenden Gruppe ausgewählt ist.

11. Wärmebeständige lichtempfindliche Harzzusammensetzung nach Anspruch 1, bei der die Menge des pulverigen Festmaterials im Bereich von 1 bis 70 Gew.-%_{,} bezogen auf die harzartigen Ingredienzien in der Zusammensetzung, liegt.

12. Wärmebeständige lichtempfindliche Harzzusammensetzung nach Anspruch 1, bei der das Härtemittel für ein Epoxyharz als Komponente (f) aus der aus Härtemitteln auf Aminbasis und kationischen Epoxy-härtenden Mitteln bestehenden Gruppe ausgewählt ist.

13. Wärmebeständige lichtempfindliche Harzzusammensetzung nach Anspruch 1, bei der die Menge des Härtemittels als Komponente (f) im Bereich von 1 bis 20 Gew.-%, bezogen auf die Menge des veresterten Harzes als Komponente (b), liegt.

14. Wärmebeständige lichtempfindliche Harzzusammensetzung nach Anspruch 1, welche außerdem ein organisches Lösungsmittel enthält.

15. Wärmebeständige lichtempfindliche Harzzusammensetzung nach Anspruch 15, bei der das organische Lösungsmittel aus der aus Ethylenglykolmonomethylether, Ethylenglykolmonoethylether, Ethylenglykolmonobutylether, Propylenglykolmonomethylether, Diethylenglykolmonoethylether, Dipropylenglykolmonoethylether, Methylethylketon, Methylisobutylketon und Cyclohexanon bestehenden Gruppe ausgewählt ist.

## Revendications

1. Composition de résine photosensible, résistant à la chaleur, qui comprend:
(a) un copolymère obtenu par copolymérisation d'un mélange de monomères comprenant de 10 à 30 % en poids d'un composé de type amide éthyléniquement insaturé répondant à la formule générale :
CH₂=CX-CO-NH-Y-OZ
dans laquelle X représente un atome d'hydrogène ou un groupe méthyle, Y représente un groupe alkylène ayant de 1 à 4 atomes de carbone et Z représente un groupe alkyle ayant de 1 à 4 atomes de carbone ou un groupe benzyle, comme premier monomère essentiel, et de 10 à 30 % en poids d'un composé éthyléniquement insaturé ayant au moins un groupe carboxy dans sa molécule comme second monomère essentiel;
(b) une résine estérifiée qui est le produit de réaction d'une résine époxy de type novolaque et d'un acide carboxylique éthyléniquement insaturé en une quantité comprise entre 0,2 à 0,8 équivalent par rapport aux groupes époxy de la résine époxy de type novolaque;
(c) un monomère photopolymérisable ayant plus d'une double liaison dans sa molécule;
(d) un initiateur de photopolymérisation;
(e) une matière solide en poudre; et
(f) un agent de durcissement pour une résine époxy.

2. Composition de résine photosensible, résistant à la chaleur selon la revendication 1, dans laquelle le premier monomère du composant (a) est choisi dans le groupe constitué par le N-méthoxyméthylacrylamide, le N-méthoxyméthylméthacrylamide, le N-éthoxyméthylacrylamide, le N-éthoxyméthylméthacrylamide, le N-propoxyméthylacrylamide, le N-propoxyméthylméthacrylamide, le N-n-butoxyméthylacrylamide, le N-n-butoxyméthylméthacrylamide, le N-isobutoxyméthylacrylamide, le N-isobutoxyméthylméthacrylamide, le N-benzyloxyméthylacrylamide, le N-n-butoxyéthylacrylamide, le N-n-butoxyéthylméthacrylamide, le N-isobutoxyéthylacrylamide et le N-isobutoxyéthylméthacrylamide.

3. Composition de résine photosensible résistant à la chaleur selon la revendication 1, dans laquelle le second monomère du composant (a) est l'acide acrylique ou l'acide méthacrylique.

4. Composition de résine photosensible résistant à la chaleur selon la revendication 1, dans laquelle l'acide carboxylique éthyléniquement insaturé ayant réagi avec une résine époxy de type novolaque pour former le composant (b) est choisi dans le groupe constitué par l'acide acrylique, l'acide méthacrylique, l'acide crotonique, le maléate de monométhyle, le maléate de monopropyle, le maléate de monobutyle et l'acide sorbique.

5. Composition de résine photosensible résistant à la chaleur selon la revendication 1, dans laquelle le monomère photopolymérisable utilisé comme composant (c) est choisi dans le groupe constitué par le diacrylate de 1,6-hexanediol, le triacrylate de triméthylolpropane, le triméthacrylate de triméthylolpropane, le diacrylate de triméthylolpropane, le diméthacrylate de triméthylolpropane, le triacrylate de tétraméthylolméthane, le triméthacrylate de tétraméthylolméthane, le tétraacrylate de tétraméthylolpropane, le tétraméthacrylate de tétraméthylolpropane, le pentaacrylate de dipentaérythritol, le pentaméthacrylate de dipentaérythritol, le 1,1,1-tri(acryloxypropoxypropoxyméthyl)propane, des acrylates de mélamine et des résines estérifiées contenant des groupe carboxy.

6. Composition de résine photosensible résistant à la chaleur selon la revendication 1, dans laquelle la quantité de résine estérifiée utilisé comme composant (b) est comprise entre 20 et 200 parties en poids pour 100 parties en poids du copolymère utilisé comme composant (a).

7. Composition de résine photosensible résistant à la chaleur selon la revendication 1, dans laquelle la quantité de monomère photopolymérisable utilisé comme composant (c) est comprise entre 25 et 250 parties en poids pour 100 parties en poids du copolymère utilisé comme composant (a).

8. Composition de résine photosensible résistant à la chaleur selon la revendication 1, dans laquelle l'initiateur de photopolymérisation utilisé comme composant (d) est choisi dans le groupe constitué par des composés de type benzophénone, des composé de type anthraquinone, des composés de type éther-oxyde alkylique de benzoïne, la 2,2-diméthoxy-2-phénylacétophénone, la 2,2-diéthoxyacétophénone, la 2-chlorothioxanthone, la diéthylthioxanthone, la 2-hydroxy-2-méthylpropiophénone, la 4'-isopropyl-2-hydroxy-2-méthylpropiophénone et la 2-méthyl-1-[4-(méthylthio)phényl]-2-morpholino-1-propanone.

9. Composition de résine photosensible résistant à la chaleur selon la revendication 1, dans laquelle la quantité d'initiateur de photopolymérisation utilisé comme composant (d) est comprise entre 0,1 et 20 % en poids, exprimé par rapport à la quantité totale de copolymère utilisé comme composant (a), de résine estérifiée utilisée comme composant (b) et de monomère photopolymérisable utilisé comme composant (c).

10. Composition de résine photosensible résistant à la chaleur selon la revendication 1, dans laquelle la matière solide en poudre utilisée comme composant (e) est choisie dans le groupe constitué par de la poudre de silice finement divisée, des paillettes de mica, du talc, de l'oxyde d'aluminium, de l'hydroxyde d'aluminium, de l'oxyde d'antimoine, de la résine de benzoguanidine sphérique, de la résine de polyimide granulaire et de la résine de polyamide granulaire.

11. Composition de résine photosensible résistant à la chaleur selon la revendication 1, dans laquelle la quantité de matière solide en poudre est comprise entre 1 et 70 % en poids, exprimé par rapport à aux ingrédients résineux de la composition.

12. Composition de résine photosensible résistant à la chaleur selon la revendication 1, dans laquelle l'agent de durcissement pour une résine époxy utilisé comme composant (f) est choisi dans le groupe constitué par des agents de durcissement à base d'amine et des agents de durcissement de résines époxy cationiques.

13. Composition de résine photosensible résistant à la chaleur selon la revendication 1, dans laquelle la quantité d'agent de durcissement utilisé comme composant (f) est comprise entre 1 et 20 % en poids, exprimé par rapport à la quantité de résine estérifiée utilisée comme composant (b).

14. Composition de résine photosensible résistant à la chaleur selon la revendication 1, qui comprend encore un solvant organique.

15. Composition de résine photosensible résistant à la chaleur selon la revendication 14, dans laquelle le solvant organique est choisi dans le groupe constitué par l'éther-oxyde monométhylique de l'éthylèneglycol, l'éther-oxyde monoéthylique de l'éthylèneglycol, l'éther-oxyde monobutylique de l'éthylèneglycol, l'éther-oxyde monométhylique du propylèneglycol, l'éther-oxyde monoéthylique du diéthylèneglycol, l'éther-oxyde monométhylique du dipropylèneglycol, la méthyléthylcétone, la méthylisobutylcétone et la cyclohexanone.
